# EUROPEAN PATENT SPECIFICATION

(11) **EP 2 151 065 B1**
(45) Date of publication and mention of the grant of the patent: **18.01.2017**
(21) Application number: 08736851.0
(22) Date of filing: 18.04.2008
(51) Int. Cl.: H04B 1/48, H04B 1/18, H04B 1/74, H03F 3/189, H03F 3/72, H04W 88/08

(54) **MASTHEAD AMPLIFIER UNIT**
MASTKOPF-VERSTÄRKEREINHEIT
UNITÉ D'AMPLIFICATEUR DE MÂT

(30) Priority: 03.05.2007 FI 20075309
(43) Date of publication of application: 10.02.2010
(73) Proprietor: Intel Corporation, Santa Clara, CA 95054 (US)
(72) Inventor: NÄRHI, Harri, FI-90440 Kempele (FI)
(74) Representative: Goddar, Heinz J.
(86) International application number: PCT/FI2008/050202
(87) International publication number: WO 2008/135630

(56) References cited:
- WO-A1-97/13331
- WO-A1-97/13331
- GB-A- 2 219 702
- US-A1- 2004 056 710
- US-A1- 2004 056 710
- US-A1- 2006 094 471
- US-B1- 6 591 086

## Description

The invention relates to an amplifier unit to be placed in an antenna mast, being in accordance with a radio system using time division duplex. The amplifier unit is suitable for use especially in the base stations of cellular networks.

In the two-way system, the transmitting and receiving can have a shared antenna, but processing signals propagating to opposite directions naturally requires their own transmission paths for both. On the receiving side, the first amplifier starting from the antenna should be as close to the antenna as possible, because the receive signal is low-level and a long intermediate cable would attenuate it even more and deteriorate the signal-to-interference ratio in the amplifier input. For this reason the transmission path divides as viewed from the antenna in its vicinity to a transmitting and a receiving branch, and the latter includes a low-noise amplifier. When the antenna is close to the receiver and the transmitter, the transmission paths naturally continue separately to them. On the contrary, when the antenna is at the top of a mast relatively far away from the transmitter and the receiver, separate intermediate cables for transmitting and receiving would cause a considerable additional cost for the equipment. For this reason, the transmission paths are usually joined again after the amplifier in the antenna mast so that an intermediate cable with only one shared transmission path for the transmitting and receiving comes down from the mast.

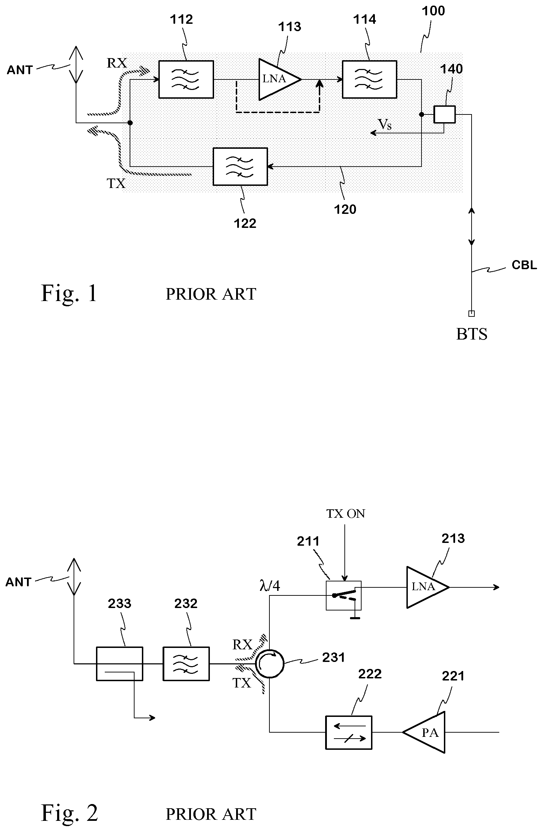

**Fig. 1** shows, for comparison, as a block diagram a typical masthead amplifier unit using FDD technique (Frequency Division Duplex). The amplifier unit 100 comprises a receiving branch and a transmitting branch in parallel. The receiving branch comprises in the propagation direction of the signal a first receive filter 112, a low-noise amplifier or LNA 113 and a second receive filter 114. The receive filters are of band-pass type and they strongly attenuate frequency components outside the receive band thus cleaning the signal being received and protecting the LNA. The transmitting branch only comprises a transmit filter 122 of band-pass type which strongly attenuates frequency components outside the transmit band thus preventing i.a. the leaking of the amplified receive signal to the input of the receiving branch. The input of the first receive filter 112 and the output of the transmit filter 122 are coupled by a shared line to the antenna ANT. The output of the second receive filter 114 and the input of the transmit filter 122 are coupled to a T-bias circuit 140. This is further coupled to the shared intermediate cable CBL, which is connected at its lower end to the other part of the base station equipment.

Via the T-bias circuit 140 is received the supply voltage V₈ to the receiving branch, needed by it.

In case of LNA damage, it can be provided with a bypass path. In Fig. 1 such a bypass path is presented only by a dash line. The bypass path requires two-way switches, by means of which it is enabled even as the LNA is disconnected from the transmission path. A masthead amplifier unit may comprise two parts like the one in Fig. 1 primarily for implementing the diversity. In this case the receiving branch of one part can be used also as a bypass path of the receiving branch of the other part.

When the TDD technique (Time Division Duplex) is used in the radio path, the bites of the signals propagating to the opposite directions are transferred in the same frequency band at different times, in their own time slots. In that case a masthead amplifier unit according to Fig. 1 does not qualify, because the filters would not prevent the transmitting and receiving signals to propagate to a wrong branch. The prevention is implemented using an antenna switch, by means of which the transmitter and the receiver are connected to the antenna in turn, or using a circulator, which passes the signal coming from the transmitter only to the antenna and the signal coming from the antenna only to the receiver. As an example about the latter way is the front stage in Fig. 2, using TDD technique and known from the publication US 2005/0255812. It comprises, starting from the antenna ANT, in order a directional coupler 233, a passband filter 232 and a circulator 231. The circulator has, in addition to an antenna port, a receiving port and a transmitting port. To the receiving port connects the receiving branch, in which a switch 211 and LNA 213 are visible, and to the transmitting port connects the transmitting branch, in which an isolator 222 and radio-frequency power amplifier 221 are visible. A signal provided by the directional coupler 233 informs about damages in the antenna, because it is proportional to the signal reflecting from the antenna. The filter 232 cleans the spectrum of both the signal to be transmitted and the received signal.

The transmission line between the circulator 231 and switch 211 has the length of the quarter wave at the operating frequencies. The switch 211 is a two-way switch, which is controlled by the signal TX ON, the state of which depends on whether a transmitting period is going on or not. In the transmitting period the switch shorts the transmission line between the circulator and switch, in which case the impedance of the line measured at the circulator is high. In the receiving period the switch naturally connects the circulator to the LNA through said transmission line.

The signal TX to be transmitted, coming from the power amplifier, is guided almost entirely towards the antenna in the circulator. The attenuation from the transmitting port to receiving port is e.g. 20 dB. In the receiving branch the high-impedance transmission line and switch 211 attenuate more the signal propagating there so that the level of the transmitting signal reaching the LNA is e.g. 65 dB lower than the level of the signal propagating to the antenna. This kind of considerable attenuation is needed because of the relatively high level of the transmitting signal.

The receiving signal RX coming from the antenna is guided almost entirely towards the LNA in the circulator. The circulator 231 and isolator 222 attenuate the receiving signal propagating to the power amplifier e.g. 20 dB.

The front stage according to Fig. 2, as such, does not lend itself to a masthead amplifier, because the transmission paths on the side of the base station are not combined in it. In respect of the transmitting branch, the combining with the receiving branch takes naturally place at the line going to the circulator, when using a masthead amplifier. When the combining is implemented, new problems regarding transmission technology have to be solved, especially when also an arranging of the bypass path for LNA in the receiving branch is demanded.

Further background art relating to the invention may be found in WO097/13331 A, US 2004/056710 A1, GB 2 219 702 A, US 2006/094471 A1.

The object of the invention is to implement a masthead amplifier unit using TDD technique, which comprises a bypass path for the low-noise amplifier and fulfils the technical requirements regarding the transmission. The amplifier unit according to the invention is characterised by what is presented in the independent claim 1. Some advantageous embodiments of the invention are described in the other claims.

The basic idea of the invention is the following: In a TDD masthead amplifier unit, which comprises a transmitting and receiving branch in parallel, there is used the transmitting branch as a bypass path for the LNA in the receiving branch. The unit is set to the transmitting mode, (normal) receiving mode and bypass mode by means of pin diode switches. A passive bypass mode comes automatically into effect, if the unit loses its supply voltage. At least one pin switch is located transversely in the transmitting branch for switching it off, when the unit is set to the receiving mode. The structure comprises advantageously another, redundant, transmitting branch with series switches, which is used for improving on the characteristics of the transmission path of the transmitting signals, when the biasing of the pin switches is possible.

An advantage of the invention is that there is, in case the LNA gain disappears, a bypass path for the receiving signal in a masthead amplifier unit, which functions in accordance with the TDD technique. Another advantage of the invention is that the transmitting branch in parallel with the receiving branch of the unit does not significantly degrade the received and amplified signal. This is because the transmitting branch of the unit is switched off when it is in the receiving mode, in which case the signals reflected from the lower end of the intermediate cable can not propagate back to the input side of the LNA. A further advantage of the invention is that the transmitting path and receiving path function, although the unit would loose its supply voltage. A further advantage of the invention is that an unit according to it can easily be provided with a redundant branch with good power handling capability and low generated intermodulation. This is based on the forward biasing of the series diodes in the branch in question.

The invention will now be described in detail. The description refers to the accompanying drawings in which
- Fig. 1: shows as a block diagram an example of the known masthead amplifier unit,
- Fig. 2: shows as a block diagram an example of the known front stage using TDD technique,
- Fig. 3: shows as a block diagram an example of the TDD masthead amplifier unit, in which the transmitting branch functions as a bypass path for the LNA in case of its damage,
- Fig. 4: shows an example of the masthead amplifier unit according to the invention,
- Fig. 5: shows a second example of the masthead amplifier unit according to the invention,
- Fig. 6: shows a third example of the masthead amplifier unit according to the invention,
- Fig. 7a: shows the amplifier unit according to Fig. 6 in the transmitting mode,
- Fig. 7b: shows the amplifier unit according to Fig. 6 in the receiving mode,
- Fig. 7c: shows the amplifier unit according to Fig. 6 in the passive bypass mode, and
- Fig. 8: shows a fourth example of the masthead amplifier unit according to the invention.

Figs. 1 and 2 were already discussed in connection with the description of prior art.

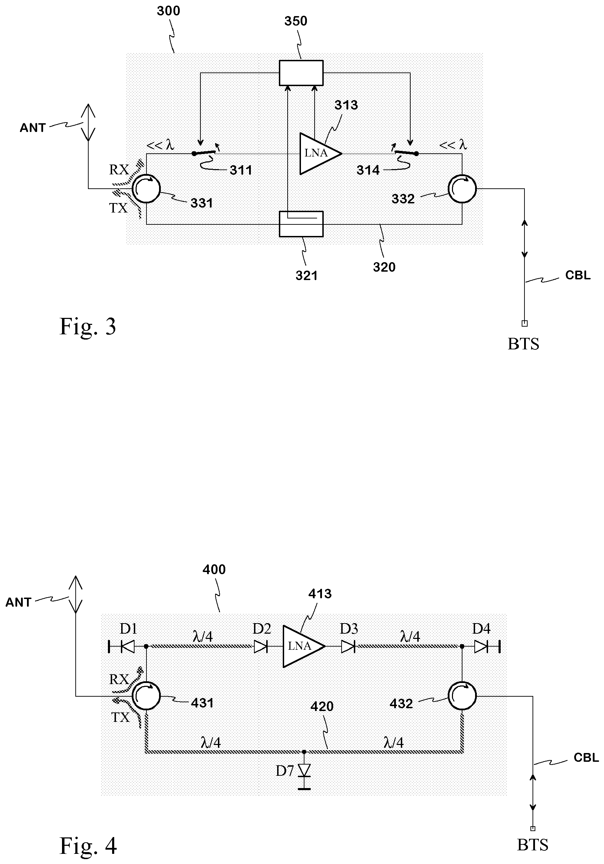

In **Fig. 3** there is an example of the TDD masthead amplifier unit, in which the transmitting branch functions as a bypass path for the LNA in case of its damage. The amplifier unit 300 is presented as a simplified principled drawing, and it serves as an introduction to the structures according to the invention proper. The unit 300 comprises a first circulator 331 on the side of the antenna ANT and a second circulator 332 on the side of the intermediate cable CBL leading to a base station. The first circulator has, in addition to an antenna port, a transmitting and receiving port, and the second circulator has, in addition to a base station port, a transmitting and receiving port. Between the receiving port of the first circulator 331 and the receiving port of the second circulator 332 there is the receiving branch of the unit, which comprises a first switch 311, the LNA 313 and the second switch 314 in series. Between the transmitting port of the second circulator 332 and the transmitting port of the first circulator there is the transmitting branch 320 of the unit, which consists of a transmission line and a directional coupler 321, through which the transmission line travels.

The directional coupler 321 provides a measuring signal proportional to the signal propagating towards the antenna, which measuring signal is taken to the control unit 350. When its level rises to a certain value, the control unit immediately outputs to the switches 311, 314 of the receiving branch a control, which sets them to non-conductive state. This takes place in every transmitting time slot of the TDD system, when a transmitting signal begins to enter from the transmitter of the base station. This way the amplifier unit is applied to the transmitting mode, wherein the LNA has been isolated from the other circuit so that only very much attenuated transmitting signal reaches the LNA.

The amplifier unit 300 is in the normal receiving mode, when both the first 311 and second 314 switch is in the conductive state. In this case the receiving signal coming from the antenna is guided in the first circulator 331 through its receiving port to the LNA and further, as amplified, in the second circulator 332 through its base station port to the intermediate cable CBL.

In case the LNA gain disappears, it is arranged a bypass path for the LNA. The gain may disappear either for the LNA damage or because the supply voltage of the whole amplifier unit vanishes. For the former case the LNA is equipped with a watching circuit, and the level of a fault signal provided by the watching circuit changes, if the gain disappears. The fault signal is led to said control unit 350, which sets to the switches 311, 314 of the receiving branch to non-conductive state also when the LNA is damaged. In this case, the amplifier unit 300 is in the bypass mode, which is then an abnormal receiving mode.

Comparing to the wavelength, the transmission line between the receiving port of the first circulator 331 and the first switch 311 is so short that a high impedance is "seen" in the receiving port, when the first switch is non-conductive. In this case the receiving signal coming from the antenna does not waste energy to the receiving port and has such a phase at the transmitting port that it can propagate to the transmitting branch 320. Correspondingly, in the second circulator 332 the receiving signal can propagate to the intermediate cable CBL, since the transmission line between the receiving port of the second circulator and the second switch 314 is very short compared to the wavelength. This way the transmitting branch functions also as the bypass path for the LNA, when the amplifier unit is in the bypass mode. In fact, in its bypass mode the whole amplifier unit 300 only is a passive lengthening of the transmission line of the intermediate cable CBL.

When there is another branch in parallel with the branch including an amplifier, an active loop is constituted. This is in principle a risk factor because of the risk of an oscillation. In order that no oscillation handicap would arise, the loop gain should be clearly less than one, for example -20 dB. In Fig. 3 this comes true, if the attenuation caused by the circulators together in the loop is clearly higher than the gain of the LNA.

When the structure according to Fig. 3 is in the (normal) receiving mode, the receiving signals reflected from the lower end of the intermediate cable may propagate through the circulators harmful strong to the input of the LNA, being there summed to the signal, which comes from the antenna. This means degradation of the receive signal quality, because the signal gone around down in the base station is naturally substantially delayed on the way. It would help if a pin diode type switch is added in series to the transmitting branch, which switch would be set conductive in the transmitting mode and non-conductive in the receiving mode. However, such a diode has to be set conductive also in the bypass mode, which requires bias current in the diode. This is a flaw, when desiring that the amplifier unit is automatically set to the bypass mode, if it looses its supply voltage. The transmitting branch can be switched off in the receiving mode and the amplifier unit can be automatically set to the bypass mode when it looses its supply voltage, if a pin switch is added to the transmitting branch transversely, instead of being in series with the conductor of the transmitting branch. "Transversely" means here that a component in question is connected between two conductors of the transmission line, which constitutes the transmission path. One of the conductors is usually the signal ground. In the receiving mode a bias current would flow in the transverse diode, and in the transmitting mode it would be non-biased. However, in this case an increase in the intermodulation in the transmitting mode would be a drawback. This is because a non-biased pin diode does not represent an infinite impedance but a certain nonlinear impedance.

In the invention pin diodes are used in the TDD masthead amplifier unit for guiding the signal propagation in the transmitting and receiving branches of the unit. In **Fig. 4** there is an example of such a masthead amplifier unit. The amplifier unit 400 is shown as simplified so that i.a. the biasing circuits of the pin diodes and the structural parts required for their control are not drawn visible. The unit 400 comprises a first circulator 431 on the side of the antenna ANT and a second circulator 432 on the side of the intermediate cable CBL leading to a base station. The first circulator has, in addition to an antenna port, a transmitting and receiving port, and the second circulator has, in addition to a base station port, a transmitting and receiving port. Between the receiving port of the first circulator 431 and the receiving port of the second circulator 432 there is the receiving branch of the unit, which comprises in order pin switch D1, pin switch D2, the LNA 413, pin switch D3 and pin switch D4. The pin switches D2 and D3 are in series with the LNA, pin switch D1 is located transversely, next the receiving port of the first circulator when leaving it, and pin switch D4 is located transversely, next the receiving port of the second circulator when leaving it backwards. Between the transmitting port of the second circulator 432 and the transmitting port of the first circulator 431 there is the transmitting branch 420 of the unit, which comprises a transmission line and pin switch D7 transversely in this transmission line.

In the transmitting mode the pin switches D1 and D4 are biased to be conductive, and the pin switches D2, D3 and D7 are not biased, they then being non-conductive. In this case the transmitting signal passes through the transmitting branch to the antenna, like in the structure presented in Fig. 3. The first circulator 431 attenuates the transmitting signal propagating at its receiving port, and the port short-circuited by pin switch D1 prevents the attenuated transmitting signal, as well as a part of the transmitting signal possibly reflected from the antenna, to propagate to the LNA. The transmission line between the receiving port and pin switch D2 in the LNA input has the length of the quarter wave at the operating frequencies, in which case its impedance measured at the receiving port is low, thus improving the short-circuit of the port.

In the receiving mode the pin switches D2, D3 and D7 are biased to be conductive and the pin switches D1 and D4 are non-conductive. In this case the receiving signal passes without hindrance to the LNA and as amplified to the intermediate cable CBL. The conductive pin switch D7 is located in the transmitting branch 420 so that both the transmission line between the transmitting port of the first circulator 431 and pin switch D7 and the transmission line between the transmitting port of the second circulator 432 and pin switch D7 have the length of the quarter wave at the operating frequencies. This means that the impedance measured at the ports in question is high. The part of the receiving signal, reflected from the lower end of the intermediate cable, reflects backwards from pin switch D7 and can not propagate through the transmitting branch to the input side of the LNA and degrade the receiving signal. On the other hand, no part of the receiving signal coming from the antenna can propagate through the transmitting branch, which improves the attenuation of the receiving signal towards the transmitting branch, implemented by the circulator.

The bypass mode can be active or passive. In the active bypass mode the control of the pin switches is identical to the one in the transmitting mode, that is the pin switches D1 and D4 are conductive and the other are non-conductive. The passive bypass mode comes true, when the amplifier unit has loosen its supply voltage, in which case all pin switches are non-conductive. Regarding the transmitting branch, which serves as the bypass path, the situation does not change compared with the active bypass mode. Unlike this, the attenuation in the receiving signal, caused by the transmission path from the antenna port of the first circulator 431 towards the receiving branch, increases somewhat because the short-circuit of pin switch D1 vanishes.

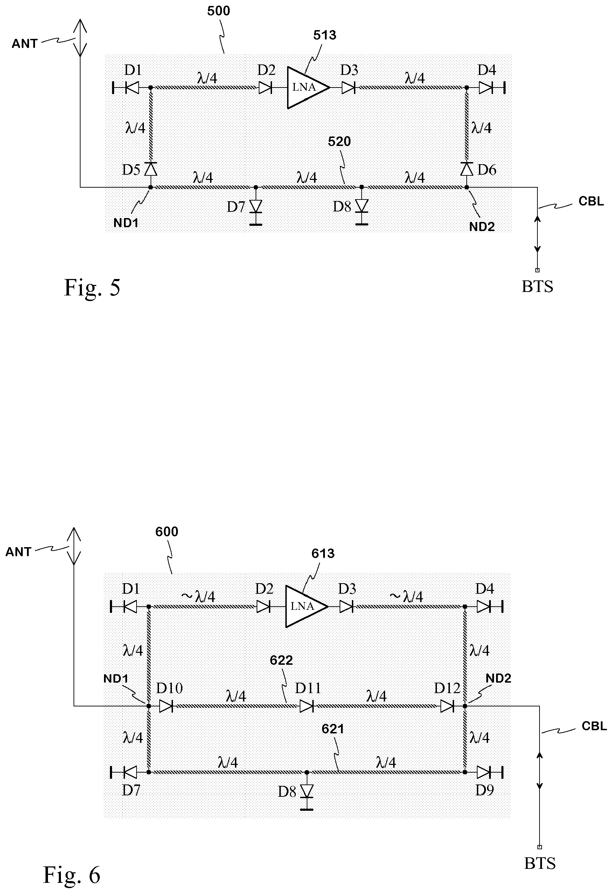

In **Fig. 5** there is a second example of the masthead amplifier unit according to the invention. Compared with the structure presented in Fig. 4, both circulators are removed and three pin switches are added. In place of the first circulator of Fig. 4 there is the first node ND1 and in place of the second circulator there is the second node ND2. The antenna port to be connected to the antenna ANT consists of a conductor connecting to the first node ND1 and the signal ground, and the base station port to be connected to the intermediate cable CBL consists of a conductor connecting to the second node ND2 and the signal ground. The receiving branch comprises now, when leaving node ND1, in order pin switch D5 in series, a quarter wave transmission line, pin switch D1 transversely, a quarter wave transmission line, pin switch D2 in series, the LNA 513, pin switch D3 in series, a quarter wave transmission line, pin switch D4 transversely, a quarter wave transmission line and pin switch D6 in series. The second terminal of the last-mentioned is connected directly to the second node ND2. The transmitting branch comprises, when leaving node ND2, in order a quarter wave transmission line, pin switch D8 transversely, a quarter wave transmission line, pin switch D7 transversely and a quarter wave transmission line. The second end of the last-mentioned is connected to the first node ND1.

In the transmitting mode the pin switches D1 and D4 of the receiving branch are biased to be conductive, and the pin switches D2, D3, D5, D6 and D7 are non-conductive. The transmitting signal then passes through the transmitting branch to the antenna. From the second node ND2 towards the receiving branch there is first the serial switch D6 with high impedance and thereafter a quarter wave transmission line short-circuited at the opposite end by pin switch D4 and the line leading to the output of the LNA. In that case the transmitting signal, which propagates to the receiving branch, first attenuates in the switch D6 and the permeated part reflects back towards node ND2. From the first node ND1 towards the receiving branch there is first the serial switch D5 with high impedance and thereafter a quarter wave transmission line short-circuited at the opposite end by pin switch D1 and the line leading to the input of the LNA. In that case the transmitting signal, which propagates to the receiving branch through node ND1, first attenuates in the switch D5 and the permeated part reflects back towards node ND1. Therefore, the attenuation measured at the input of the LNA is very high. The lines on both sides of the LNA improve the short-circuits constituted by the pin switches D1 and D4, because they have a length of the quarter wave and are open at their opposite end for the non-conductive serial switches D2 and D3.

In the receiving mode the pin switches D2, D3, D5, D6, D7 and D8 biased to be conductive, and the pin switches D1 and D4 are non-conductive. The receiving signal then passes without hindrance to the LNA and as amplified to the intermediate cable CBL. The part of the receiving signal, reflected from the lower end of the intermediate cable and propagating from node ND2 to the transmitting branch 520, reflects from the short-circuited pin switch D8 back towards node ND2. In addition, the minor part, which continues forwards from pin switch D8, reflects back from the short-circuited pin switch D7. The receiving signal reflected from the lower end of the intermediate cable can then not propagate through the transmitting branch to the input side of the LNA and degrade the receiving signal. Correspondingly, the receiving signal arriving from the antenna can not propagate to the transmitting branch, which propagation would attenuate the signal proceeding to the LNA. The signal reflected from the lower end of the intermediate cable and propagating from the second node ND2 to the receiving branch vanishes for the most part in the matching impedance at the LNA output.

As mentioned before, the loop gain in the loop constituted of the receiving branch and transmitting branch is a crucial factor in the receiving mode because of the risk of oscillation. In the structure according to Fig. 5 the short-circuited quarter-wavelength lines in the transmitting branch lower effectively the loop gain.

Also here, the active bypass mode is same as the transmitting mode, and in the passive bypass mode all pin switches are non-conductive. Regarding the transmitting branch, which serves as the bypass path, the situation does not change compared with the active bypass mode. Unlike this, the attenuation in the receiving signal, caused by the transmission path from the first node ND1 towards the receiving branch, increases somewhat because the short-circuit of pin switch D1 ceases. Correspondingly, the attenuation in the receiving signal, caused by the transmission path from the second node ND2 towards the receiving branch, increases because the short-circuit of pin switch D4 ceases.

A unit according to Fig. 5 being in the transmitting mode, the non-biased diodes in the transmitting branch deteriorate the ability to handle the transmitting signal, when the power becomes higher, and cause remarkable intermodulation, when the transmitting power is relatively high. In this respect the amplifier unit to be explained next, shown in Fig. 6, represents an improved solution.

In **Fig. 6** there is a third example of the masthead amplifier unit according to the invention. Compared with the structure 500 presented in Fig. 5, a second transmitting branch 622 has been added to the amplifier unit 600 parallel to the first transmitting branch 621 and the receiving branch which includes the LNA 613. Three parallel branches combine in the first node ND1 and form the antenna port, and they combine in the second node ND2 and form the base station port. The antenna port is naturally connected to the antenna ANT by a relatively short transmission line, and the base station port is connected to the base station by a relatively long intermediate cable CBL.

The added second transmitting branch 622 includes three pin switches in series: Pin switch D10 is located next node ND1 when leaving it, pin switch D11 in the middle of the branch 622 and pin switch D12 next node ND2 when arriving at it. The transmission line formed by the signal ground and the conductor between the switches D10 and D11 has the length of the quarter wave like also the transmission line formed by the signal ground and the conductor between the switches D11 and D12. The first transmitting branch 621 is like the transmitting branch 520 shown in Fig. 5 with difference that the number of the transverse pin switches is now three instead of two and, correspondingly, the number of the quarter wave transmission lines in series is now four instead of three. The receiving branch is like the receiving branch shown in Fig. 5 with difference that the series switches D5 and D6, connected directly to the nodes ND1 and ND2, are missing. The receiving branch then comprises, when leaving node ND1, in order a quarter wave transmission line, pin switch D1 transversely, a transmission line having a length about the quarter wave, pin switch D2 in series, the LNA 613, pin switch D3 in series, a transmission line having a length about the quarter wave, pin switch D4 transversely and a quarter wave transmission line.

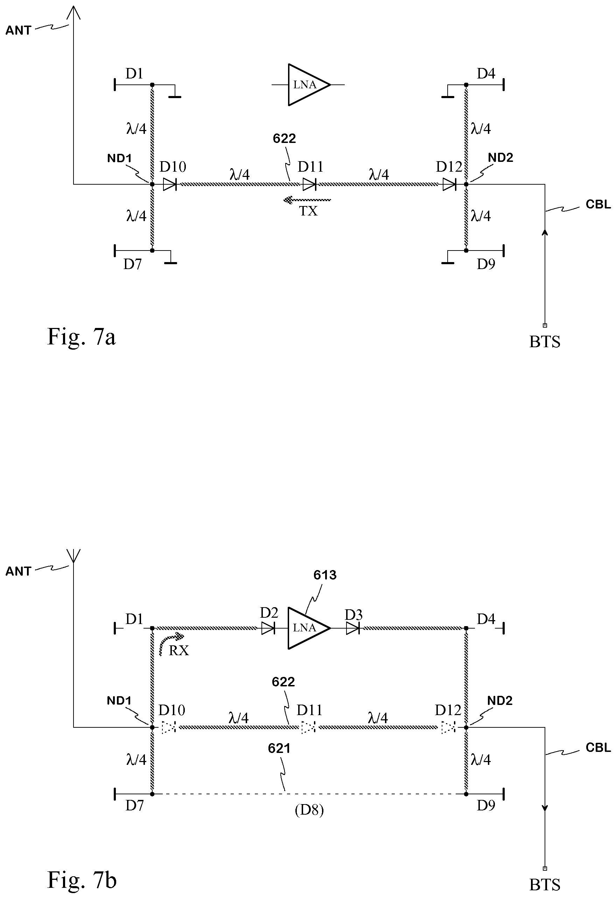

In **Fig. 7a** there is the masthead amplifier unit 600 according to Fig. 6 in the transmitting mode. The structure of the unit is presented illustratively from the functional point such that the transverse pin switches D1, D4, D7 and D9, which are biased to be conductive, are drawn as short-circuits. The pin switches D2 and D3 at the input and output of the LNA are non-conductive, for which reason also the quarter-wavelength lines ending to those switches are drawn as short-circuits. The transverse pin switch D8 in the middle of the first transmitting branch 621 is non-conductive, for which reason a short-circuited half-wavelength line is seen in the branch in question from the pin switches D7 and D9 towards each other. The impedance of such a line is very low so that also it is presented as short-circuits in Fig. 7a. On grounds of the matter above there is, from the first node ND1 towards the receiving branch, a quarter-wavelength line short-circuited at the opposite end, or a high impedance which protects the LNA input against the transmitting signal. Similarly there is a high impedance from the first node towards the first transmitting branch and from the second node ND2 towards both the receiving branch and the first transmitting branch.

The pin switches D10, D11 and D12 in the second transmitting branch 622 are biased to be conductive so that the second transmitting branch functions as the transmission path of the transmitting signal TX, when the unit is in the transmitting mode. The pin switches are in series, and their bias current is so high that they function linearly also when the transmitting power is relatively high. Because of this, the intermodulation distortion (IMD) in the signal is minor. The number of the switches in the second transmitting branch relates to the reducing of the loop gain, when the unit is in the receiving mode. This is explained more accurately below in connection with Fig. 7b.

The second transmitting branch 622 functions as a bypass path of the LNA, when the LNA has been damaged and the biasing circuits of the pin switches receive their supply voltage. The active bypass mode of the amplifier unit is then same as its transmitting mode.

In **Fig. 7b** there is the masthead amplifier unit 600 according to Fig. 6 in the receiving mode. The structure of the unit is presented illustratively from the functional point such that the transverse pin switches D7 and D9, which are biased to be conductive, are drawn as short-circuits, the non-conductive transverse pin switches D1 and D4 are drawn as cut conductors, and the non-conductive pin switches D10, D11 and D12 in series in the second transmitting branch 622 are drawn with broken lines.

The pin switches D2 and D3 at the input and output of the LNA are now conductive, of course. For this reason, when the transverse switches D1 and D4 are non-conductive, the receiving signal RX passes without hindrance to the LNA input and as amplified to the intermediate cable CBL. Both the input and output of the LNA are naturally matched to the impedance of the transmission lines of the receiving branch, in which case the length of the these transmission lines has not much importance in the receiving mode.

There is, from both the first node ND1 and the second node ND2 towards the first transmitting branch 621, a quarter-wavelength line short-circuited at the opposite end because of the conductivity of the pin switches D7 and D9, or a high impedance. Also the transverse pin switch D8 in the middle of the first transmitting branch is biased to be conductive, in which case a short-circuited quarter-wavelength line, or a high impedance, is seen onwards from the pin switches D7 and D9 towards each other. This portion of the first transmitting branch is drawn with broken line in Fig. 7b.

Although both transmitting branches 621, 622 are cut in principle, in practice they pass something anyway. Thus they constitute a loop with the receiving branch, the overall gain of which, or the loop gain, should be clearly less than one, as discussed before. The higher attenuation in the transmitting branch, the lower loop gain. In the first transmitting branch 621 the attenuation is enhanced by that also pin switch D8 is conductive. In that case there are, forwards from the second node ND2 in the circulating direction, three successive quarter-wavelength lines short-circuited at the opposite end. Also in the second transmitting branch 622 the attenuation is enhanced by successive quarter-wavelength portions. In the example of Fig. 7b the number of such portions in the second transmitting branch is two, and they are (nearly) open at their both ends. Only a minor fraction of the coming field continues forwards from the point of a non-conductive switch. In addition, the field reflected fron the open tail end has an opposite phase at the starting end in respect of the leaving field, in which case field cancelling takes place (energy radiates). If an adequate attenuation is not achieved by two quarter-wavelength portions, the number of the switches and at the same time the quarter-wavelength lines between them can be increased.

The above-described attenuation in the transmitting branches 621, 622 applies as well to the part of the receiving signal, which has reflected from the lower end of the intermediate cable CBL and propagates to the transmitting branches from the second node ND2. Such a reflection can then not propagate to the input side of the LNA and degrade the receiving signal.

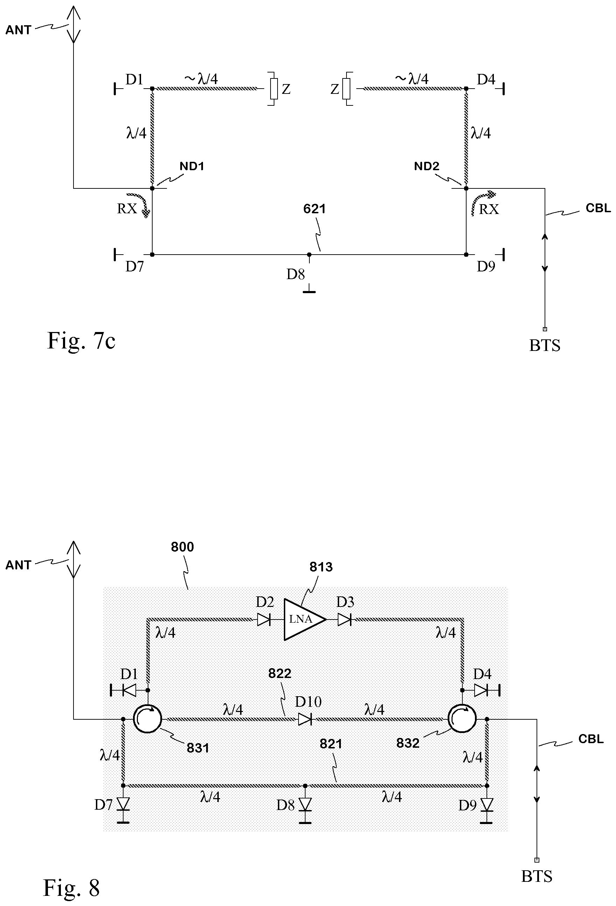

In **Fig. 7c** there is the masthead amplifier unit 600 according to Fig. 6 in the passive bypass mode, in which case all pin switches are non-conductive. The non-conductive transverse pin switches D1, D4, D7, D8 and D9 are drawn as cut conductors. The second transmitting branch 622 is not drawn visible, because it is insignificant when the LNA is out off action.

The receiving signal RX can propagate to the intermediate cable CBL through the first transmitting branch 621 and the transmitting signal to the antenna ANT along the same route in the reverse direction in the time slot of its own.

A high impedance has to exist from both the first node ND1 and the second node ND2 towards the receiving branch in order that the impedance of the transmission path of the weak receiving signal would not have any incontinuity. A half-wavelength line open at its opposite end would represent a sufficient high impedance. In the structure to be considered the matching impedances of the LNA with typical value of 50Ω cause that the transmission lines connecting to the input and output of the LNA are not fully open, although the matching impedances are, seen from the nodes ND1 and ND2, behind the non-conductive pin switches. For this reason impedances Z, representing the factual terminal impedances of the transmission lines in question, are marked in Fig. 7c. The effective impedances from the nodes ND1 and ND2 towards the receiving branch can be made sufficient high, when the lengths of the transmission lines are tuned suitably. This results in that the length of the transmission lines between the pin switches D1 and D4 and the LNA is, instead of the length of the quarter wave, for example about 85 % of the length of the quarter wave.

In **Fig. 8** there is a fourth example of the masthead amplifier unit according to the invention. The amplifier unit 800 comprises a redundant second transmitting branch 822 with a serial switch like the structure shown in Fig. 6. The first transmitting branch 821 is fully similar as in Fig. 6. A notable difference in respect of Fig. 6 is that there are now circulators in place of the nodes ND1 and ND2. Due to this, the receiving branch including the LNA 813 is similar to the one in the structure shown in Fig. 4, which uses circulators. It comprises then in the propagation direction of the signal in order a transverse pin switch D1, a quarter-wavelength transmission line, pin switch D2 in series, the LNA 813, pin switch D3 in series, a quarter-wavelength transmission line and a transverse pin switch D4. The first circulator 831 has an antenna port to be connected to the antenna ANT, a receiving port and a transmitting port, and the second circulator 832 has a base station port to be connected to the intermediate cable CBL of a base station, a receiving port and a transmitting port. The receiving branch of the unit starts from the receiving port of the first circulator and ends at the receiving port of the second circulator. The first transmitting branch 821 starts from the base station port of the second circulator and ends at the antenna port of the first circulator. The second transmitting branch 822 starts from the transmitting port of the second circulator and ends at the transmitting port of the first circulator.

The second transmitting branch 822 comprises only one serial switch D10, while in Fig. 6 the number of switches is three. One switch is enough, because a sufficient attenuation takes place in the circulators in the loop from the LNA ouput to the LNA input.

Above was described a masthead amplifier unit according to the invention. Its structure can naturally deviate in details from the ones shown in Figs. 4-8. For example the number of the transverse and serial pin switches in the branches of the unit can vary more than it appears from said figures. Changing the number of the switches in a branch means at the same time a change in that how the branch in question is divided to the portions with length of the quarter wave. A circulator can be used, differing from the structure shown in Fig. 8, for example only at the unit's end to be connected to the antenna. The control of the pin switches can be based on a directional coupler in the first transmitting branch and an internal control unit of the amplifier unit similarly as in Fig. 3. The control signal can also be brought to the control unit from the base station through the intermediate cable CBL. The fault signal of the LNA can further be used, like in the structure shown in Fig. 3, for connecting the amplifier unit to the active bypass mode when the LNA is damaged. The inventive idea can be applied in different ways within the limitations set by the independent claim 1.

## Claims

1. An amplifier unit (400; 500; 600; 800) to be mounted to an antenna mast, which unit comprises a transmitting branch (420; 520; 621; 821) and a receiving branch with a low-noise amplifier (413; 513; 613; 813), or a LNA, an output of which transmitting branch and an input of the receiving branch are coupled together for connecting to an antenna (ANT) by a shared line and an input of the transmitting branch and an output of the receiving branch are coupled together for connecting to a shared intermediate cable (CBL), which leads down from the mast, **characterized in that** it has a transmitting and receiving mode to function in accordance with the TDD technique and an active and passive bypass mode in case a LNA gain disappears, the transmitting branch serves as a transmission path of a receiving signal (RX) at any rate in the active bypass mode, the amplifier unit (400; 500; 600; 800) comprises, to set a mode, at least one pin switch (D1; D2) in series with the LNA to switch the receiving branch off in the transmitting mode and at least one pin switch (D7; D7, D8; D7, D8, D9) transversely in the transmitting branch to switch it off in the receiving mode, the amplifier unit then being automatically in the passive bypass mode, when its supply voltage has vanished.

2. An amplifier unit according to claim 1, **characterized in that** it further comprises a second transmitting branch (622; 822) with at least one pin switch (D10, D 11, D 12; D10) in series to improve on the characteristics of a transmission path of a transmitting signal (TX) as far as intermodulation distortion, IMD, is concerned, when the biasing of the pin switches is possible.

3. An amplifier unit according to claim 2, **characterized in that** the output of both transmitting branches (621, 622) and the input of the receiving branch are coupled directly together resulting in a first node (ND1), and the input of both transmitting branches and the output of the receiving branch are coupled directly together resulting in a second node (ND2).

4. An amplifier unit according to claim 3, **characterized in that** the number of the pin switches (D10, D11, D12) in the second transmitting branch is three, one of them being located at the input of the branch in question, the second one being located in the middle of the branch and the third one being located at the output of the branch, and a portion of the transmission path of the branch between two successive pin switches has a length of the quarter wave at the operating frequencies.

5. An amplifier unit according to claim 2, **characterized in that** it further comprises a first circulator (831) with an antenna port, a receiving port and a transmitting port and a second circulator (832) with a base station port to be connected to said intermediate cable (CBL), a receiving port and a transmitting port, in which case the output of the second transmitting branch (822) is connected to the transmitting port of the first circulator and the input of the receiving branch is connected to the receiving port of the first circulator, and the input of the second transmitting branch is connected to the transmitting port of the second circulator and the output of the receiving branch is connected to the receiving port of the second circulator, and the output of the first transmitting branch (821) is connected to the antenna port of the first circulator (831) and the input of the first transmitting branch is connected to the base station port of the second circulator (832).

6. An amplifier unit according to claim 1, **characterized in that** the output of the transmitting branch (520) and the input of the receiving branch are coupled directly together resulting in a first node (ND1), and the input of the transmitting branch and the output of the receiving branch are coupled directly together resulting in a second node (ND2).

7. An amplifier unit according to claim 3 or 6, **characterized in that** the receiving branch comprises, in order from the first node (ND1) to the second node (ND2), at the operating frequencies a quarter wave transmission line, a pin switch (D1) transversely, a quarter wave transmission line, a pin switch (D2) in series, a LNA (513; 613), a pin switch (D3) in series, a transmission line having a length of the quarter wave, a pin switch (D4) transversely and a quarter wave transmission line.

8. An amplifier unit according to claim 1, **characterized in that** the number of the pin switches (D7, D8, D9) in the transmitting branch is three, and the transmission path of the transmitting branch is divided to four portions with a length of the quarter wave at the operating frequencies so that there is one of said pin switches between every two successive portions.

9. An amplifier unit according to claim 1, **characterized in that** it further comprises a first circulator (431) with an antenna port, a receiving port and a transmitting port and a second circulator (432) with a base station port to be connected to said intermediate cable (CBL), a receiving port and a transmitting port, in which case the output of the transmitting branch (420) is connected to the transmitting port of the first circulator and the input of the receiving branch is connected to the receiving port of the first circulator, and the input of the transmitting branch is connected to the transmitting port of the second circulator and the output of the receiving branch is connected to the receiving port of the second circulator.

10. An amplifier unit according to claim 1, comprising a control unit to control the pin switches, **characterized in that** it comprises a directional coupler being located in the first transmitting branch to provide information about beginning of a TDD transmitting time slot, a measuring output of which directional coupler being connected to the control unit to set the amplifier unit to the transmitting mode for the duration of the TDD transmitting time slots.

11. An amplifier unit according to claim 1, comprising a control unit to control the pin switches, **characterized in that** the control unit is arranged to provide information about beginning of a TDD transmitting time slot from the base station through the intermediate cable CBL to set the amplifier unit to the transmitting mode for the duration of the TDD transmitting time slots.

12. An amplifier unit according to claim 1, which comprises a control unit to control the pin switches and the LNA of which is arranged to output a fault signal when it is damaged, **characterized in that** an output of the LNA fault signal is connected to the control unit to set the amplifier unit to the active bypass mode when the LNA is damaged.

## Patentansprüche

1. Verstärkereinheit (400; 500; 600; 800), die auf einen Antennenmast montiert wird, wobei die Einheit einen Sendezweig (420; 520;, 621; 821) und einen Empfangszweig mit einem rauscharmen Verstärker (Low-Noise Amplifier, LNA) (413; 513; 613; 813) umfasst, wobei ein Ausgang des Sendezweigs und ein Eingang des Empfangszweigs für eine Verbindung mit einer Antenne (ANT) durch eine gemeinsam genutzte Leitung miteinander verbunden sind und wobei ein Eingang des Sendezweigs und ein Ausgang des Empfangszweigs für eine Verbindung mit einer gemeinsam genutzten Steigleitung (CBL) miteinander verbunden sind, die von dem Mast nach unten führt, **dadurch gekennzeichnet, dass** die Einheit einen Sendemodus und einen Empfangsmodus aufweist, um gemäß der TDD-Technik zu funktionieren, sowie einen aktiven und einen passiven Überbrückungsmodus umfasst, für den Fall, dass eine LNA-Verstärkung verschwindet; dass der Sendezweig als ein Sendepfad eines Empfangssignals (RX) bei einer beliebigen Rate in dem aktiven Überbrückungsmodus dient, wobei die Verstärkereinheit (400; 500; 600; 800) zum Einstellen eines Modus mindestens einen Stiftschalter (D1; D2), der mit dem LNA in Reihe geschaltet ist, um den Empfangszweig in dem Sendemodus auszuschalten, und mindestens einen Stiftschalter (D7; D7, D8; D7, D8, D9) umfasst, der in dem Sendezweig quer geschaltet ist, um diesen in dem Empfangsmodus auszuschalten, wobei die Verstärkereinheit, wenn die Versorgungsspannung verloren wurde, automatisch in den passiven Überbrückungsmodus geht.

2. Verstärkereinheit nach Anspruch 1, **dadurch gekennzeichnet, dass** sie außerdem einen zweiten Sendezweig (622; 822) mit mindestens einem in Reihe geschalteten Stiftschalter (D10, D11, D12; D10) umfasst, um die Eigenschaften eines Sendepfads eines Sendesignals (TX) zu verbessern, soweit eine Intermodulationsverzerrung (Intermodulation Distortion, IMD) betroffen ist, wenn ein Vorspannen der Stiftschalter möglich ist.

3. Verstärkereinheit nach Anspruch 2, **dadurch gekennzeichnet, dass** der Ausgang beider Sendezweige (621, 622) und der Eingang des Empfangszweigs direkt miteinander verbunden sind, was zu einem ersten Knoten (ND1) führt, und dass der Eingang beider Sendezweige und der Ausgang des Empfangszweigs direkt miteinander verbunden sind, was zu einem zweiten Knoten (ND2) führt.

4. Verstärkereinheit nach Anspruch 3, **dadurch gekennzeichnet, dass** die Anzahl der Stiftschalter (D10, D11, D12) in dem zweiten Sendezweig drei ist, wobei einer von ihnen am Eingang des betroffenen Zweigs angebracht ist, wobei der Zweite in der Mitte des Zweigs angebracht ist und wobei der Dritte am Ausgang des Zweigs angebracht ist, und wobei ein Abschnitt des Sendepfads des Zweigs zwischen zwei aufeinanderfolgenden Stiftschaltern eine Länge einer Viertelwelle bei den Betriebsfrequenzen aufweist.

5. Verstärkereinheit nach Anspruch 2, **dadurch gekennzeichnet, dass** sie außerdem einen ersten Zirkulator (831) mit einem Antennenanschluss, einem Empfangsanschluss und einem Sendeanschluss und einen zweiten Zirkulator (832) mit einem Basisstationsanschluss, der mit der Steigleitung (CBL) verbunden wird, einem Empfangsanschluss und einem Sendeanschluss umfasst, wobei der Ausgang des zweiten Sendezweigs (822) mit dem Sendeanschluss des ersten Zirkulators und der Eingang des Empfangszweigs mit dem Empfangsanschluss des ersten Zirkulators verbunden ist und wobei der Eingang des zweiten Sendezweigs mit dem Sendeanschluss des zweiten Zirkulators und der Ausgang des Empfangszweigs mit dem Empfangsanschluss des zweiten Zirkulators verbunden ist und wobei der Ausgang des ersten Sendezweigs (821) mit dem Antennenanschluss des ersten Zirkulators (831) und der Eingang des ersten Sendezweigs mit dem Basisstationsanschluss des zweiten Zirkulators (832) verbunden ist.

6. Verstärkereinheit nach Anspruch 1, **dadurch gekennzeichnet, dass** der Ausgang des Sendezweigs (520) und der Eingang des Empfangszweigs direkt miteinander verbunden sind, was zu einem ersten Knoten (ND1) führt, und dass der Eingang des Sendezweigs und der Ausgang des Empfangszweigs direkt miteinander verbunden sind, was zu einem zweiten Knoten (ND2) führt.

7. Verstärkereinheit nach Anspruch 3 oder 6, **dadurch gekennzeichnet, dass** der Empfangszweig vom ersten Knoten (ND1) zum zweiten Knoten (ND2) umfasst: eine Viertelwellensendeleitung für die Betriebsfrequenzen, einen quergeschalteten Stiftschalter (D1), eine Viertelwellensendeleitung, einen in Reihe geschalteten Stiftschalter (D2), einen LNA (513; 613), einen in Reihe geschalteten Stiftschalter (D3), eine Sendeleitung, welche eine Länge der Viertelwelle aufweist, einen quergeschalteten Stiftschalter (D4) und eine Viertelwellensendeleitung.

8. Verstärkereinheit nach Anspruch 1, **dadurch gekennzeichnet, dass** die Anzahl der Stiftschalter (D7, D8, D9) in dem Sendezweig drei beträgt und dass der Sendepfad des Sendezweigs in vier Abschnitte mit einer Länge der Viertelwelle bei den Betriebsfrequenzen geteilt ist, sodass zwischen jedem der aufeinanderfolgenden Abschnitte jeweils ein Stiftschalter vorhanden ist.

9. Verstärkereinheit nach Anspruch 1, **dadurch gekennzeichnet, dass** sie außerdem einen ersten Zirkulator (431) mit einem Antennenanschluss, einem Empfangsanschluss und einem Sendeanschluss und einen zweiten Zirkulator (432) mit einem Basisstationsanschluss, der mit der Steigleitung (CBL) verbunden wird, einem Empfangsanschluss und einem Sendeanschluss umfasst, wobei der Ausgang des Sendezweigs (420) mit dem Sendeanschluss des ersten Zirkulators und der Eingang des Empfangszweigs mit dem Empfangsanschluss des ersten Zirkulators verbunden ist und wobei der Eingang des Sendezweigs mit dem Sendeanschluss des zweiten Zirkulators und der Ausgang des Empfangszweigs mit dem Empfangsanschluss des zweiten Zirkulators verbunden ist.

10. Verstärkereinheit nach Anspruch 1, die eine Steuereinheit zum Steuern der Stiftschalter umfasst, **dadurch gekennzeichnet, dass** sie einen Richtungskoppler umfasst, der in dem ersten Sendezweig angebracht ist, um Informationen über den Start eines TDD-Sendezeitschlitzes bereitzustellen, wobei ein Messausgang des Richtungskopplers mit der Steuereinheit verbunden ist, um die Verstärkereinheit während der Dauer des TDD-Sendezeitschlitzes in den Sendemodus zu setzen.

11. Verstärkereinheit nach Anspruch 1, die eine Steuereinheit zum Steuern der Stiftschalter umfasst, **dadurch gekennzeichnet, dass** die Steuereinheit geeignet ist, um Informationen über den Start eines TDD-Sendezeitschlitzes von der Basisstation durch die Steigleitung (CBL) bereitzustellen, um die Verstärkereinheit während der Dauer des TDD-Sendezeitschlitzes in den Sendemodus zu setzen.

12. Verstärkereinheit nach Anspruch 1, die eine Steuereinheit zum Steuern der Stiftschalter umfasst und deren LNA geeignet ist, ein Fehlersignal auszugeben, wenn er beschädigt ist, **dadurch gekennzeichnet, dass** ein Ausgang des LNA-Fehlersignals mit der Steuereinheit verbunden ist, um die Verstärkereinheit in den aktiven Überbrückungsmodus zu setzen, wenn der LNA beschädigt ist.

## Revendications

1. Unité d'amplification (400 ; 500 ; 600 ; 800) destinée à être montée sur un mât d'antenne, laquelle unité comprend une branche de transmission (420 ; 520 ; 621 ; 821) et une branche de réception avec un amplificateur à faible bruit (413 ; 513 ; 613 ; 813) ; ou LNA, une sortie de la branche de transmission et une entrée de la branche de réception sont couplées ensemble pour la connexion à une antenne (ANT) par une ligne partagée et une entrée de la branche de transmission et une sortie de la branche de réception sont couplées ensemble pour la connexion à un câble intermédiaire partagé (CBL), qui descend vers le bas à partir du mât, **caractérisée en ce qu'**elle possède un mode de transmission et de réception pour fonctionner selon la technique TDD et un mode de dérivation actif et passif dans le cas où un gain de LNA disparaît, la branche de transmission sert de chemin de transmission d'un signal de réception (RX) à n'importe quel débit dans le mode de dérivation actif, l'unité d'amplification (400 ; 500 ; 600 ; 800) comprend, pour régler un mode, au moins un commutateur à broche (D1 ; D2) en série avec le LNA pour couper la branche de réception dans le mode de transmission, et au moins un commutateur à broche (D7 ; D7, D8 ; D7, D8, D9) transversalement dans la branche de transmission pour la couper dans le mode de réception, l'unité d'amplification étant alors automatiquement dans le mode de dérivation passif, lorsque sa tension d'alimentation a disparu.

2. Unité d'amplification selon la revendication 1, **caractérisée en ce qu'**elle comprend en outre une seconde branche de transmission (622 ; 822) avec au moins un commutateur à broche (D10, D11, D12 ; D10) en série pour améliorer les caractéristiques d'une voie de transmission d'un signal de transmission (TX) en ce qui concerne la distorsion d'intermodulation, IMD, lorsque la polarisation des commutateurs à broche est possible.

3. Unité d'amplification selon la revendication 2, **caractérisée en ce que** la sortie des deux branches de transmission (621, 622) et l'entrée de la branche de réception sont couplées directement entre elles résultant en un premier noeud (ND1), et l'entrée des deux branches de transmission et la sortie de la branche de réception sont couplées directement entre elles résultant en un second noeud (ND2).

4. Unité d'amplification selon la revendication 3, **caractérisée en ce que** le nombre des commutateurs à broche (D10, D11, D12) dans la seconde branche de transmission est de trois, l'un d'entre eux étant situé au niveau de l'entrée de la branche concernée, le second étant situé au milieu de la branche et le troisième étant situé au niveau de la sortie de la branche, et une partie du chemin de transmission de la branche entre deux commutateurs à broche successifs a une longueur du quart d'onde aux fréquences de fonctionnement.

5. Unité d'amplification selon la revendication 2, **caractérisée en ce qu'**elle comprend en outre un premier circulateur (831) avec un port d'antenne, un port de réception et un port de transmission et un second circulateur (832) avec un port de station de base pour être connecté audit câble intermédiaire (CBL), un port de réception et un port de transmission, auquel cas la sortie de la seconde branche de transmission (822) est connectée au port de transmission du premier circulateur et l'entrée de la branche de réception est connectée au port de réception du premier circulateur, et l'entrée de la seconde branche de transmission est connectée au port de transmission du second circulateur, et la sortie de la branche de réception est connectée au port de réception du second circulateur, et la sortie de la première branche de transmission (821) est connectée au port d'antenne du premier circulateur (831), et l'entrée de la première branche de transmission est connectée au port de station de base du second circulateur (832).

6. Unité d'amplification selon la revendication 1, **caractérisée en ce que** la sortie de la branche de transmission (520) et l'entrée de la branche de réception sont couplées directement l'une à l'autre résultant en un premier noeud (ND1) et l'entrée de la branche de transmission et la sortie de la branche de réception sont couplées directement l'une à l'autre résultant en un second noeud (ND2).

7. Unité d'amplification selon la revendication 3 ou 6, **caractérisée en ce que** la branche de réception comprend, dans l'ordre du premier noeud (ND1) au second noeud (ND2), aux fréquences de fonctionnement, une ligne de transmission de quart d'onde, un commutateur à broche (D1) transversalement, une ligne de transmission de quart d'onde, un commutateur à broche (D2) en série, un LNA (513 ; 613), un commutateur à broche (D3) en série, une ligne de transmission ayant une longueur du quart d'onde, un commutateur à broche (D4) transversalement, et une ligne de transmission de quart d'onde.

8. Unité d'amplification selon la revendication 1, **caractérisée en ce que** le nombre de commutateurs à broche (D7, D8, D9) dans la branche de transmission est de trois, et le chemin de transmission de la branche de transmission est divisé en quatre parties avec une longueur du quart d'onde aux fréquences de fonctionnement, de telle sorte qu'un desdits commutateurs à broches est placé entre deux parties successives.

9. Unité d'amplification selon la revendication 1, **caractérisée en ce qu'**elle comprend en outre un premier circulateur (431) avec un port d'antenne, un port de réception et un port de transmission, et un second circulateur (432) avec un port de station de base pour être connecté audit câble intermédiaire (CBL), un port de réception et un port de transmission, auquel cas la sortie de la branche de transmission (420) est connectée au port de transmission du premier circulateur et l'entrée de la branche de réception est connectée au port de réception du premier circulateur, et l'entrée de la branche de transmission est connectée au port de transmission du second circulateur et la sortie de la branche de réception est connectée au port de réception du second circulateur.

10. Unité d'amplification selon la revendication 1, comprenant une unité de commande pour commander les commutateurs à broche, **caractérisée en ce qu'**elle comprend un coupleur directionnel situé dans la première branche de transmission pour fournir des informations sur le début d'un intervalle de temps de transmission TDD, une sortie de mesure dudit coupleur directionnel étant connectée à l'unité de commande pour mettre l'unité d'amplification sur le mode de transmission pendant la durée des intervalles de temps de transmission TDD.

11. Unité d'amplification selon la revendication 1, comprenant une unité de commande pour commander les commutateurs à broche, **caractérisée en ce que** l'unité de commande est agencée pour fournir des informations sur le début d'un intervalle de temps de transmission TDD à partir de la station de base par l'intermédiaire du câble intermédiaire CBL pour mettre l'unité d'amplification sur le mode de transmission pendant la durée des intervalles de temps de transmission TDD.

12. Unité d'amplification selon la revendication 1, qui comprend une unité de commande pour commander les commutateurs à broche et dont le LNA est agencé pour délivrer un signal de défaut lorsqu'il est endommagé, **caractérisée en ce qu'**une sortie du signal de défaut de LNA est connectée à l'unité de commande pour mettre l'unité d'amplification sur le mode de dérivation actif lorsque le LNA est endommagé.
